# EUROPÄISCHE PATENTSCHRIFT

(11) **EP 2 838 123 B1**
(45) Veröffentlichungstag und Bekanntmachung des Hinweises auf die Patenterteilung: **16.03.2016**
(21) Anmeldenummer: 13180396.7
(22) Anmeldetag: 14.08.2013
(51) Int. Cl.: H01L 31/18, B23K 1/00, B23K 1/002, B23K 3/047, B23K 3/08, H05K 3/34

(54) **Löteinrichtung zum Verbinden von Solarzellen**
Welding device for connecting solar cells
Dispositif de soudure destiné à relier des cellules solaires

(43) Veröffentlichungstag der Anmeldung: 18.02.2015
(73) Patentinhaber: Komax Holding AG, 6036 Dierikon (CH)
(72) Erfinder: Morf, Peter, 8052 Zürich (CH); Hofer, Adolf, 8426 Lufingen (CH); Kaufmann, Stefan, 5000 Aarau (CH)
(74) Vertreter: Blöchle, Hans

(56) Entgegenhaltungen:
- EP-A1- 2 103 373
- EP-A1- 2 607 007
- EP-A1- 2 607 008
- WO-A1-80/02662
- WO-A1-2011/009948
- WO-A1-2011/012175
- US-A1- 2013 277 361

## Beschreibung

Die Erfindung betrifft eine Löteinrichtung zum Verbinden von Solarzellen gemäss dem Oberbegriff von Anspruch 1. Die auf dem Induktionsprinzip arbeitende Löteinrichtung weist bevorzugt für jede Leiterbahn eine Induktorschleife auf, mit der ein hochfrequentes Magnetfeld zum Löten eines Leiters an die Solarzellen in einer Leiterbahn erzeugbar ist. Eine gattungsmässig vergleichbare Löteinrichtung zum Verbinden von Solarzellen ist aus der WO 2011/012175 A1 bekannt geworden. Die Löteinrichtung weist eine Induktorschleife in U-Form auf, durch die Niederhalter zum Pressen des Leiters auf die Leiterbahn der Solarzelle geführt sind. Die Schenkel der U-förmigen Induktorschleife sind wellenförmig geformt, wobei die Niederhalter jeweils im Bereich einer Aufweitung die Induktorschleife durchdringen. Die Niederhalter bestehen jeweils aus einem magnetfeldneutralen Material. Im Bereich der Aufweitungen kann die Induktorschleife aus einem Ferrit bestehen oder von einem Ferit umgeben sein. In einer anderen Variante sind an der Induktorschleife Rohrteile aus Ferrit angebracht, durch die jeweils ein Niederhalte-Stift geführt werden kann. Die Ferrite bewirken jeweils eine Konzentration des Magnetfelds. Die in der WO 2011/012175 A1 gezeigten Lösungsansätze zur Konzentration des Magnetfelds sind aufwändig und dadurch vergleichsweise teuer. Für spezielle Anwendungsgebiete, beispielsweise wenn nur auf sehr kleinen Flächen induktiv gelötet werden soll, kann das Erreichen dieses Ziels mit dieser Löteinrichtung schwierig sein.

Es ist deshalb die Aufgabe der vorliegenden Erfindung, eine Löteinrichtung zu schaffen, mit der einfach und kostengünstig Solarzellen durch induktives Löten verbunden werden können. Die mit der Löteinrichtung gefertigten Lötstellen sollen qualitativ hohen Anforderungen genügen. Die Löteinrichtung soll weiter insbesondere dazu geeignet sein, in optimaler und präziser Weise auf sehr kleinen Flächen zu löten.

Diese Aufgaben werden mit einer Löteinrichtung gelöst, die die Merkmale von Anspruch 1 aufweist. Die erfindungsgemässe Löteinrichtung verfügt über eine auf dem Induktionsprinzip arbeitende Wärmequelle mit einer Induktorschleife zum Erzeugen eines hochfrequenten Magnetfelds zum Löten des Leiters an die Solarzellen. Zum Betreiben der Induktorschleife kann die Wärmequelle weiterhin einen Hochfrequenzgenerator aufweisen. Ein hochfrequenter Strom des Hochfrequenzgenerators erzeugt ein hochfrequentes Magnetfeld, das über die Induktorschleife in der Leiterbahn und in dem entlang der Leiterbahn angeordneten elektrischen Leiter Wirbelströme induziert, die die für den Lötvorgang notwendige Wärme erzeugen. Die Löteinrichtung umfasst weiter wenigstens einen, vorteilhaft mehrere Niederhalter zum Pressen des Leiters auf die Leiterbahn der Solarzelle. Der oder die Niederhalter sind dabei als Feldkonzentratoren ausgeführt, wodurch das Magnetfeld im Zielbereich, in dem gelötet werden soll, lokal verstärkt und konzentriert werden kann. Versuche mit solchen Niederhaltern, die Feldkonzentrations-Eigenschaften aufweisen, haben überaschenderweise gezeigt, dass hervorragende Lötergebnisse erzielbar sind. Insbesondere lassen sich so auch Stellen mit sehr kleinen Flächen in präziser Weise induktiv verlöten. Es können herkömmliche Induktorschleifen verwendet werden, die keine Ferrite aufweisen oder von Ferriten umgeben sind. Die erfindungsgemässe Anordnung ist kostengünstig und zeichnet sich durch einen einfachen Aufbau auf. Bestehende Löteinrichtungen lassen sich einfach durch Ersetzen der bisherigen Niederhalter mit den beschriebenen Feldkonzentrator-Niederhalter umrüsten.

Die Induktorschleife kann U-förmig ausgebildet sein. Die Schenkel des U können auf einer planparallelen Ebene zu den Solarzellenoberflächen verlaufen. Analog zur WO 2011/012175 A1 können die Schenkel wellenförmig geformt sein. Zum Bilden der Wellenform kann die Induktorschleife Verringerungen und Aufweitungen umfassen, mit denen die Wärmeentwicklung in den Lötzonen weiter optimiert werden können. Jede Aufweitung kann je einen Zugang zu einer Lötstelle für einen Niederhalter bieten.

Der Niederhalter könnte ein aktiver Feldkonzentrator mit wenigstens einer Magnetspule sein. Die Magnetspule könnte in diesem Fall derart ausgerichtet sein, dass die Feldlinien des aktiven Feldkonzentrators und der Induktorschleife etwa gleichgerichtet werden. Bevorzugt ist der wenigstens eine Niederhalter jedoch als passiver Feldkonzentrator ausgeführt und besteht wenigstens teilweise aus einem Ferrit oder einem anderen Material mit hoher magnetischer Permeabilität oder der Niederhalter enthält ein solches Material.

Besonders bevorzugt kann es sein, wenn der wenigstens eine Niederhalter einen Niederhalter-Stift aufweist, der aus einem Ferrit oder einem anderen Material mit hoher magnetischer Permeabilität besteht. Dieser Niederhalter-Ferritstift kann beispielsweise eine zylindrische Aussenkontur aufweisen. Das freie Ende des Niederhalter-Stifts, das der Solarzelle zugewandt ist, kann eine Auflagefläche zum Beaufschlagen des Leiters zum Pressen des Leiters auf die Leiterbahn der Solarzelle aufweisen. Solche Ferritstifte sind kostengünstig erwerbbar und einfach herstellbar.

Vorteilhaft kann es sein, wenn der wenigstens einen Niederhalter einen Niederhalter-Stift mit einem rohrförmigen Grundkörper aufweist, wobei im vorderen, der Solarzelle zugewandten Ende des Grundkörpers ein Feldkonzentrator-Element aus einem Ferrit oder einem anderen Material mit hohem magnetischer Permeabilität im Hohlraum des Grundkörpers angeordnet ist. Das Feldkonzentrator-Element kann beispielsweise im Inneren des Grundkörpers eingeklebt oder eingeklemmt sein. Selbstverständlich sind auch andere Befestigungsmöglichkeiten denkbar. Der rohrförmige Grundkörper kann magnetfeldneutrale Eigenschaften aufweisen und aus Glas, keramischen Materialien oder einem Kunststoffmaterial bestehen.

Für bestimmte Anwendungsgebiete kann es vorteilhafter sein, wenn der rohrförmige Grundkörper im Bereich des vorderen Endes offen ausgestaltet ist. Das Feldkonzentrator-Element kann bündig zum freien Ende des Rohrs positioniert sein. Es wäre aber auch vorstellbar, dass das Feldkonzentrator-Element gegenüber dem vorderen, freien Ende des rohrförmigen Grundkörpers zurückversetzt angeordnet wäre, wodurch das Feldkonzentrator-Element den Leiter nicht direkt berühren kann.

Alternativ kann der rohrförmige Grundkörper wenigstens im Bereich des vorderen Endes geschlossen sein. Auf diese Weise kann sichergestellt werden, dass das im Grundkörper angeordnete Feldkonzentrator-Element nicht direkt den zu verlötenden Leiter berührt.

Der Niederhalter kann einen rohrförmigen Grundkörper mit einem monolithisch am Grundkörper angeformten Boden zum Schliessen des vorderen Endes des Grundkörpers aufweisen. Alternativ kann am vorderen, der Solarzelle zugewandten Ende des Grundkörpers, ein Fussteil befestigt sein, das eine Auflagefläche bildet, die beim Pressvorgang den Leiter beaufschlägt. Das Fussteil kann zum Vergrössern der Auflagefläche gegenüber dem Grundkörper verbreitert sein. Wenn der Grundkörper zylindrisch ausgebildet ist, kann es vorteilhaft sein, dass das Fussteil eine kreisförmige Auflagefläche vorgibt, dessen Kreisdurchmesser grösser als der Zylinderdurchmesser des Grundkörpers ist.

Weiterhin kann es vorteilhaft sein, wenn der wenigstens eine Niederhalter die Induktorschleife durchdringt. Bevorzugt ist die Induktorschleife aus einem metallischen Material gefertigt. Die Induktorschleife muss keine Feldkonzentrations-Eigenschaften aufweisen. Eine derartige Anordnung ist kostengünstig, wobei zugleich gute Lötergebnisse erzielbar sind.

Besonders bevorzugt ist es, wenn die Löteinrichtung eine Vielzahl von den vorgängig beschriebenen Niederhaltern aufweist.

In verfahrensmässiger Hinsicht zeichnet sich die Erfindung dadurch aus, dass als Feldkonzentratoren ausgeführte Niederhalter verwendet werden, mit denen das durch einen vorzugsweise mittels eines Hochfrequenzgenerators und einer Induktorschleife erzeugte hochfrequente Magnetfeld lokal verstärkt und konzentriert wird. Dieses Lötverfahren zum Verbinden von Solarzellen zeichnet sich unter anderem dadurch aus, dass kleine Lötstellen mit hoher Präzision erzeugt werden können.

Weitere Einzelmerkmale und Vorteile ergeben sich aus der nachfolgenden Beschreibung von Ausführungsbeispielen und aus den Zeichnungen. Es zeigen:
- Figur 1: eine perspektivische Darstellung einer Induktorschleife mit Niederhaltern einer erfindungsgemässen Löteinrichtung zum Verbinden von Solarzellen,
- Figur 2: eine vereinfachte perspektivische Darstellung einer alternativen Induktorschleife mit Niederhaltern für eine Löteinrichtung,
- Figur 3: einer der Niederhalter aus Figur 2 in einer anderen perspektivischen Darstellung,
- Figur 4: einen Längsschnitt durch einen Niederhalter, der eine Induktorschleife durchdringt,
- Figur 5: eine alternative Ausgestaltung des Niederhalters gemäss Figur 4,
- Figur 6: ein drittes Ausführungsbeispiel für einen Niederhalter, und
- Figur 7: einen Niederhalter gemäss einem vierten Ausführungsbeispiel.

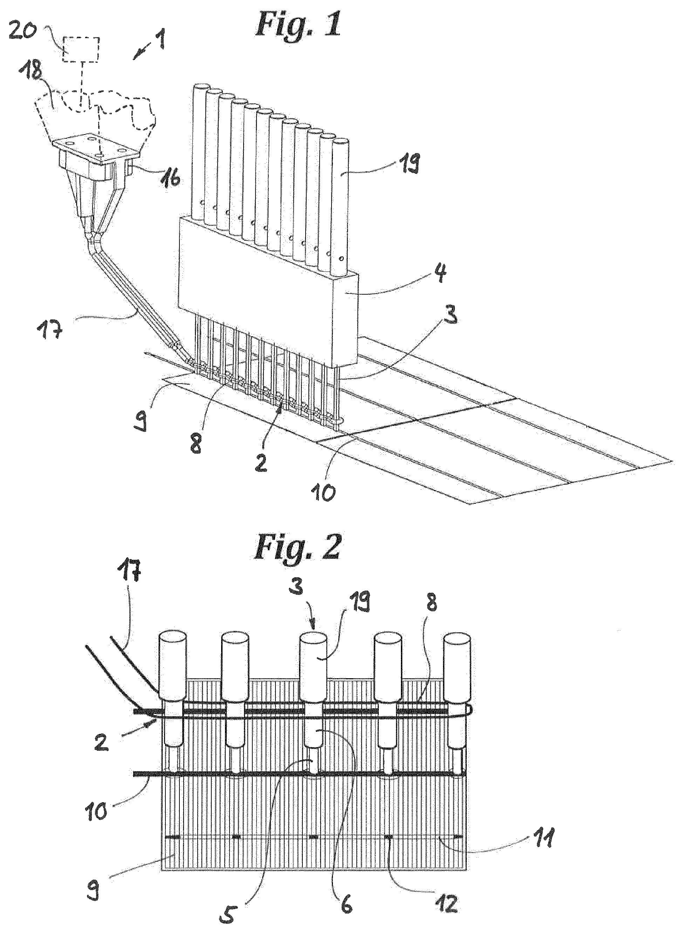

Figur 1 zeigt eine insgesamt mit 1 bezeichnete Löteinrichtung zum Verbinden von Solarzellen, bei welcher der elektromagnetische Induktionseffekt zur Wärmeerzeugung zum Löten der elektrischen Leiter 10 auf die Solarzellen verwendet wird. Die Löteinrichtung 1 umfasst eine auf dem Induktionsprinzip arbeitende Wärmequelle. Die Wärmequelle verfügt über einen Hochfrequenzgenerator, der in Figur 1 schematisch mit 20 angedeutet ist. Der Hochfrequenzgenerator 20 ist mit einem mit 18 angedeuteten Lötkopf verbunden, an dem die mit 2 bezeichnete Induktorschleife zum Erzeugen eines hochfrequenten Magnetfelds für den Lötprozess angeordnet ist. Diese auf dem Induktionsprinzip arbeitende Wärmequelle, die mittels des Hochfrequenzgenerators 20 in der Induktorschleife 2 einen hochfrequenten Strom beispielsweise mit einer Frequenz von 800 kHz bis 900 kHz erzeugt, bewirkt ein hochfrequentes Magnetfeld. Mit der Löteinrichtung 1 lassen sich die Solarzellen 9 elektrisch miteinander verbinden, wobei elektrische Leiter 10 (z.B. Kupferbändchen) an die Leiterbahnen an den Oberseiten der Solarzellen gelötet werden.

In der Darstellung gemäss Figur 1 weisen die Solarzellen beispielhaft jeweils drei parallele Leiterbahnen auf. Entsprechend werden benachbarte Solarzellen 9 unter Verwendung von drei Leitern verbunden. Der Einfachheit halber und für ein besseres Verständnis ist in Figur 1 lediglich eine Induktorschleife 2 dargestellt. An sich weist die Löteinrichtung 1 zwei weitere (nicht dargestellte) Induktorschleifen auf, die am Lötkopf 18 angeordnet sein können. Mit dem Lötkopf 18 können somit die drei Leiterbahnen auf ihrer gesamten Zellenlänge mittels dreier Induktorschleifen 2 gleichzeitig verlötet werden. Grundsätzlich wären aber auch andere Schleifenanordnungen denkbar. Anstatt je Leiterbahn jeweils eine Induktorschleife vorzusehen, wäre es selbstverständlich zum Beispiel auch möglich, mit einer einzigen, jedoch quer verschiebbaren Induktorschleife Solarzellen elektrisch zu verbinden.

Die Induktorschleife 2 weist ein am Lötkopf 18 befestigtes oder befestigbares Anschlussstück 16, ein daran anschliessendes Anschlussstück 16 und einen U-förmigen Schenkelabschnitt 8 auf. Das Anschlussstück 16 dient als Träger für die Induktorschleife 2 und umfasst den Wasseranschluss, den elektrischen Anschluss und den Hochfrequenzgenerator zur Erzeugung des hochfrequenten Stromes in der Induktorschleife 2. Der Schenkelabschnitt 8 ist von der Oberseite der Solarzelle 9 beabstandet und verläuft entlang der Leiterbahnen der Solarzellen. Die durch Rohre gebildeten Schenkel des Schenkelabschnitts 8 sind ersichtlicherweise wellenförmig geformt, wodurch Verengungen und Aufweitungen gebildet werden. Die Induktorschleife 2 wird im Bereich der Aufweitungen von Niederhaltern 3 durchdringt, mit denen der Leiter 10 auf die Leiterbahn der Solarzelle 9 gepresst wird. Das Bezugszeichen 4 steht für eine Kassette zum Halten der Niederhalter, mit 19 sind Gewichte zum Anpressen der Niederhalter bezeichnet. Bis auf die nachfolgend im Detail gezeigte und erläuterte spezielle Ausgestaltung der Niederhalter 3 sind derartige oder ähnliche Löteinrichtungen - bis auf die nachfolgend im Detail beschriebenen Niederhalter - dem Fachmann an sich schon bekannt. Bezüglich weiterer konstruktiver Details für die Löteinrichtung wird deshalb auf das vorerwähnte Dokument WO 2011/012175 verwiesen.

In Figur 2 beaufschlagen die Niederhalter-Stifte 5 den der mittleren Leiterbahn zugeordneten Leiter 10. Auf die vordere, mit 11 bezeichnete Leiterbahn wurde noch kein Leiter abgelegt. Die Kontaktzonen, die nachfolgend verlötet werden sollen, sind mit 12 bezeichnet.

Wie aus Figur 2 hervorgeht, muss die Induktorschleife 2 nicht unbedingt wellenförmig ausgestaltet sein und Verengungen und Aufweitungen aufweisen. Im vorliegenden Beispiel sind die über dem Leiter 10 angeordneten Schenkel des U-förmigen Schenkelabschnitts 8 gerade ausgestaltet. Figur 2 zeigt eine Induktorschleife 2 mit mehreren, die Schleife durchdringenden Niederhaltern 3. Die Niederhalter 3 weisen Niederhalte-Stifte 5 auf, die den Leiter 10 auf die zugehörige Leiterbahn der Solarzelle 9 pressen. Im Gegensatz zu den aus dem Stand der Technik bekannten Niederhaltern, die durch Anpressen nur der lagemässigen Fixierung der Leiter auf die Solarzellen vor und während des Lötvorgangs dienen, haben die erfindungsgemässen Niederhalter 3 eine zusätzliche Funktion. Die Niederhalter 3 verhindern nicht nur ein unbeabsichtigtes Verrutschen der abgelegten Leiter 10, sondern sie wirken beim induktiven Lötprozess mit, da die Niederhalter 3 als Feldkonzentratoren ausgeführt sind. Der jeweilige Niederhalter 3 ist als passiver Feldkonzentrator ausgeführt und besteht wenigstens teilweise aus einem Ferrit oder einem anderen Material mit hoher magnetischer Permeabilität. Die Führungshülsen können fix in einem (hier nicht dargestellten) Gehäuse (beispielsweise der in Fig. 1 gezeigten Kassette 4) montiert sein. Der Lötvorgang beginnt damit, dass der Lötkopf zusammen mit dem erwähnten Gehäuse von einer oberen Position zu einer Lötposition abgesenkt wird. Bevor diese Position erreicht ist, kommen die Niederhalter bereits mit dem Kontaktstreifen in Kontakt und pressen diese auf die Solarzellen. Dies geschieht durch die Gewichtskraft der Niederhalter 3 mit den Gewichten 19. Die Niederhalter 3 sind in den Führungshülsen 6 in vertikaler Richtung frei beweglich gelagert, wobei beispielsweise dank einer Schulter an den Gewichten sichergestellt ist, dass die ein Herausfallen aus dem Gehäuse möglich ist. Selbstverständlich wäre es auch denkbar, dass die Niederhalter (z.B. mittels Pneumatikzylindern) aktiv abgesenkt werden. Die Führungshülsen müssen keine Feldkonzentrations-Eigenschaften aufweisen. Zusätzlich zu den als Feldkonzentratoren ausgestalteten Niederhalter-Stiften könnten die Führungshülsen aber auch aus Ferrit bestehen.

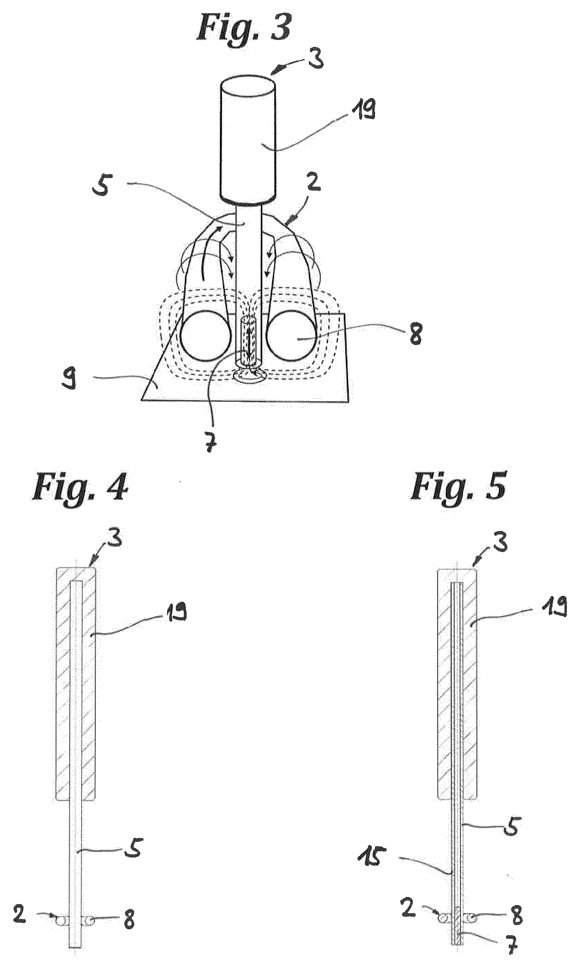

Die Wirkungsweise des als Feldkonzentrator ausgeführten Niederhalters 3 erschliesst sich aus Figur 3. Das von der Induktorschleife 2 erzeugte hochfrequente Magnetfeld ist mit gegensinnig orientierten, halbkreisförmigen Pfeilen angedeutet. Im Niederhalter-Stift 5 ist ein Feldkonzentrator-Element 7 beispielsweise aus Ferrit angeordnet. Die Feldlinien um den Feldkonzentrator sind durch gestrichelte Linien angedeutet. Ersichtlicherweise ergibt sich dank dem Feldkonzentrator-Element 7 eine lokale Verstärkung und Konzentration des Magnetfelds. Die Wärmeentwicklung beschränkt sich somit auf eine vergleichsweise kleine Fläche. Das mit der Löteinrichtung durchführbare Lötverfahren zum Verbinden von Solarzellen zeichnet sich somit ersichtlicherweise dadurch aus, dass kleine Lötstellen mit hoher Präzision erzeugt werden können.

Figur 4 zeigt einen Niederhalter 3 mit einem von einer Führungshülse 6 getragenen Niederhalterstift 5, wobei der Niederhalter-Stift 5 aus einem Ferrit gefertigt ist. Selbstverständlich wäre es aber auch möglich, den Niederhalter-Stift aus einem anderen Material mit hoher magnetischer Permeabilität herzustellen.

Die Figuren 5 bis 7 zeigen Varianten, bei denen der beispielsweise in einer (nicht dargestellten) einem Gehäuse der Löteinrichtung zugeordneten Führungshülse in vertikaler Richtung beweglich gelagerten oder geführten Niederhalter-Stift 5 zwei- oder mehrteilig aufgebaut ist. Anstatt den ganzen Niederhalter-Stift als Feldkonzentrator auszuführen, ist in den Niederhalter-Stiften gemäss den Figuren 5 bis 7 ein separates Element 7 angeordnet, das aus einem Material mit hoher magnetischer Permeabilität (z.B. Ferrit) besteht. Dieses Element, das nachfolgend als Feldkonzentrator-Element bezeichnet wird, ist im Bereich der vorderen Enden der Niederhalter-Stifte angeordnet.

In Figur 5 besteht der Niederhalter-Stift 5 aus einem rohrförmigen Grundkörper 15 in dem ein Feldkonzentrator-Element 7 angeordnet ist. Der Grundkörper 15 ist ein zylindrisches Rohr, das beispielsweise aus Glas, Keramik oder einem Kunststoff besteht. Das Rohr 15 ist daher an sich magnetfeldneutral. Im vorderen, der Solarzelle zugewandten, offenen Ende des rohrförmigen Grundkörpers 15 ist das Feldkonzentrator-Element 7 aus einem Ferrit angeordnet. Das Feldkonzentrator-Element kann beispielsweise im Inneren des Grundkörpers 15 eingeklebt oder eingeklemmt sein.

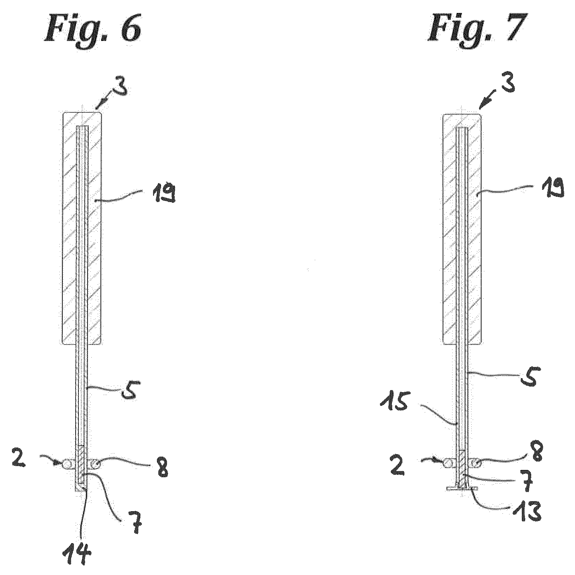

Im Ausführungsbeispiel gemäss Figur 6 ist der Grundkörper für den Niederhalter-Stift 5 im Bereich des freien Endes verschlossen. Am rohrförmigen Abschnitt schliesst vorne ein Boden 14 an. Somit ist gewährleistet, dass das Feldkonzentrator-Element 7 nicht direkt den Leiter berühren kann. Anstatt eines am Rohr angeformten Bodens kann der Niederhalter-Stift 5 auch mit einem separaten Bauteil ausgerüstet sein, das den rohrförmigen Abschnitt verschliesst.

In Figur 7 ist am rohrförmigen Grundkörper 15 ein Fussteil 13 befestigt. Das gegenüber dem Grundkörper 15 verbreiterte Fussteil13 bildet so eine vergrösserte Auflagefläche, die beim Pressvorgang den Leiter beaufschlägt.

## Patentansprüche

1. Löteinrichtung zum Verbinden von Solarzellen (9) umfassend:
- eine auf dem Induktionsprinzip arbeitende Wärmequelle, mit der mit Lötmittel versehene Leiterbahnen (11) der Solarzellen (9) mit elektrischen Leitern (10) verbindbar sind, wobei die Wärmequelle eine Induktorschleife (2) zum Erzeugen eines hochfrequenten Magnetfelds zum Löten der Leiter an die Solarzellen aufweist, und
- wenigstens einen Niederhalter (3) zum Pressen des Leiters (10) auf die Leiterbahn (11) der Solarzelle (9), **dadurch gekennzeichnet, dass** der wenigstens eine Niederhalter (3) als Feldkonzentrator ausgeführt ist, wodurch das Magnetfeld lokal verstärkt und konzentriert werden kann.

2. Löteinrichtung nach Anspruch 1, **dadurch gekennzeichnet, dass** der wenigstens eine Niederhalter (3) wenigstens teilweise aus einem Ferrit oder einem anderen Material mit hoher magnetischer Permeabilität besteht oder ein solches Material enthält.

3. Löteinrichtung nach Anspruch 1 oder 2, **dadurch gekennzeichnet, dass** der wenigstens eine Niederhalter (3) einen Niederhalter-Stift (5) aufweist, der aus einem Ferrit oder einem anderen Material mit hoher magnetischer Permeabilität besteht.

4. Löteinrichtung nach einem der Ansprüche 1 bis 3, **dadurch gekennzeichnet, dass** der wenigstens eine Niederhalter (3) einen Niederhalter-Stift (5) mit einem rohrförmigen Grundkörper (15) aufweist, wobei im vorderen, der Solarzelle zugewandten Ende des Grundkörpers ein Feldkonzentrator-Element (7) aus einem Ferrit oder einem anderen Material mit hoher magnetischer Permeabilität im Hohlraum des Grundkörpers angeordnet ist.

5. Löteinrichtung nach Anspruch 4, **dadurch gekennzeichnet, dass** der rohrförmige Grundkörper (15) im Bereich des vorderen Endes offen ausgestaltet ist.

6. Löteinrichtung nach Anspruch 4, **dadurch gekennzeichnet, dass** der rohrförmige Grundkörper (15) wenigstens im Bereich des vorderen Endes geschlossen ist.

7. Löteinrichtung nach Anspruch 6, **dadurch gekennzeichnet, dass** der rohrförmige Grundkörper (15) ein monolithisch am Grundkörper angeformter Boden (14) zum Schliessen des vorderen Endes des Grundkörpers oder dass am vorderen Ende des Grundkörpers (15) ein vorzugsweise gegenüber dem Grundkörper zum Vergrössern der Auflagefläche verbreitertes Fussteil (13) befestigt ist.

8. Löteinrichtung nach einem der Ansprüche 1 bis 7, **dadurch gekennzeichnet, dass** der wenigstens eine Niederhalter (3) die Induktorschleife (2) durchdringt.

## Claims

1. Soldering equipment for connecting solar cells (9), comprising:
- a heat source, which operates on the induction principle and by which conductor tracks (11) which are provided with solder, of the solar cells (9) are connectible with electrical conductors (10), wherein the heat source comprises an inductor loop (2) for generating a high-frequency magnetic field for soldering the conductors to the solar cells, and
- at least one holding-down device (3) for pressing the conductor (10) onto the conductor track (11) of the solar cell (9),
**characterised in that**
the at least one holding-down device (3) is constructed as a field concentrator, whereby the magnetic field can be locally amplified and concentrated.

2. Soldering equipment according to claim 1, **characterised in that** the at least one holding-down device (3) consists at least partly of a ferrite or another material with high magnetic permeability or contains such a material.

3. Soldering equipment according to claim 1 or 2, **characterised in that** the at least one holding-down device (3) comprises a pressing-down pin (5), which consists of a ferrite or another material with high magnetic permeability.

4. Soldering equipment according to any one of claims 1 to 3, **characterised in that** the at least one holding-down device (3) comprises a pressing-down pin (5) with a tubular base body (15), wherein a field-concentrator element (7) of a ferrite or another material with high magnetic permeability is arranged in the cavity of the base body in the front end of the base body facing the solar cell.

5. Soldering equipment according to claim 4, **characterised in that** the tubular base body (15) is formed to be open in the region of the front end.

6. Soldering equipment according to claim 4, **characterised in that** the tubular base body (15) is closed at least in the region of the front end.

7. Soldering equipment according to claim 6, **characterised in that** the tubular base body (15) is a base (14), which is monolithically formed at the base body, for closing the front end of the base body or that a foot part (13), which is preferably widened relative to the base body to increase the support area, is fastened to the front end of the base body (15).

8. Soldering equipment according to any one of claims 1 to 7, **characterised in that** the at least one holding-down device (3) penetrates the inductor loop (2).

## Revendications

1. Dispositif de soudage pour relier des cellules solaires (9), comprenant :
- une source de chaleur qui fonctionne selon le principe d'induction et grâce à laquelle des pistes conductrices (11), pourvues d'un agent de soudage, des cellules solaires (9), sont aptes à être reliées à des conducteurs électriques (10), étant précisé que la source de chaleur comporte une boucle d'induction (2) pour produire un champ magnétique haute fréquence en vue de souder les conducteurs aux cellules solaires, et
- au moins un serre-flan (3) pour presser le conducteur (10) sur la piste conductrice (11) de la cellule solaire (9), **caractérisé en ce que**
le ou les serre-flan (3) sont conçus comme des concentrateurs de champ, moyennant quoi le champ magnétique peut être localement intensifié et concentré.

2. Dispositif de soudage selon la revendication 1, **caractérisé en ce que** le ou les serre-flan (3) se composent au moins en partie d'une ferrite ou d'un autre matériau à haute perméabilité magnétique ou contiennent un tel matériau.

3. Dispositif de soudage selon la revendication 1 ou 2, **caractérisé en ce que** le ou les serre-flan (3) comportent une tige serre-flan (5) qui se compose au moins en partie d'une ferrite ou d'un autre matériau à haute perméabilité magnétique.

4. Dispositif de soudage selon l'une des revendications 1 à 3, **caractérisé en ce que** le ou les serre-flan (3) comportent une tige serre-flan (5) avec un corps de base tubulaire (15), étant précisé que dans l'extrémité avant du corps de base tournée vers la cellule solaire, un élément concentrateur de champ (7) composé d'une ferrite ou d'un autre matériau à haute perméabilité magnétique est disposé dans la cavité du corps de base.

5. Dispositif de soudage selon la revendication 4, **caractérisé en ce que** le corps de base tubulaire (15) est ouvert dans la zone de son extrémité avant.

6. Dispositif de soudage selon la revendication 4, **caractérisé en ce que** le corps de base tubulaire (15) est fermé au moins dans la zone de son extrémité avant.

7. Dispositif de soudage selon la revendication 6, **caractérisé en ce que** le corps de base tubulaire (15) comporte un fond (14) rapporté de manière monolithique sur le corps de base, pour fermer l'extrémité avant dudit corps de base, ou **en ce qu'**il est prévu, fixée à l'extrémité avant du corps de base (15), une partie formant pied (13) de préférence élargie par rapport au corps de base, pour agrandir la surface d'appui.

8. Dispositif de soudage selon l'une des revendications 1 à 7, **caractérisé en ce que** le ou les serre-flan (3) traversent la boucle d'induction (2).
